# EUROPEAN PATENT SPECIFICATION

(11) **EP 4 602 452 B1**
(45) Date of publication and mention of the grant of the patent: **21.10.2026**
(21) Application number: 23951684.2
(22) Date of filing: 13.09.2023
(51) Int. Cl.: G06F 3/02, H01H 13/7065, H02S 40/00

(54) **MECHANICAL KEYBOARD WITH SOLAR CELL LAYER LOCATED BENEATH**
MECHANISCHE TASTATUR MIT DARUNTER BEFINDLICHER SOLARZELLENSCHICHT
CLAVIER MÉCANIQUE AVEC COUCHE DE CELLULES SOLAIRES SITUÉE EN DESSOUS

(43) Date of publication of application: 20.08.2025
(73) Proprietor: Home Control Singapore Pte. Ltd., Singapore 556741 (SG)
(72) Inventor: CHEAH, Chen Wee, Singapore 544735 (SG); CHONG, Pok Yap, Singapore 828700 (SG)
(74) Representative: Botti & Ferrari S.p.A.
(86) International application number: PCT/SG2023/050622
(87) International publication number: WO 2025/058558

(56) References cited:
- CN-A- 116 483 211
- JP-B2- 3 252 984
- US-A1- 2009 308 722
- US-A1- 2011 298 718

## Description

### TECHNICAL CONTRIBUTION

The present invention generally relates to an electronic device with a solar cell layer, and more particularly relates to a mechanical keyboard with a solar cell layer located beneath the keyboard.

### BACKGROUND

Document US 2009/308722 A1 discloses a solar-powered mechanical keyboard comprising a keyboard body with a plurality of keys, wherein each key is separately selectable by a user with a key press and a conductive layer with conductive traces, located beneath the keyboard body and a solar cell battery and a circuitry in electrical connection to the solar cell battery; wherein each of the plurality of keys and the conductive layer is configured to define an air gap therebetween; wherein each of the plurality of keys is configured to travel downward to make contact with the conductive traces of the conductive layer. Said keyboard may be used as an input device of a computer system i.e. personal computer.

Document CN 116 483 211 A discloses a solar-powered keyboard comprising light-transmitting conductive film includes a first film and a second film oppositely arranged defining an air gap.

The quest for renewable energy sources has seen an exponential growth in recent years. Solar energy has emerged as a leading contender due to its abundance and potential for widespread adoption. However, integrating solar cells into existing devices without compromising their functionality and aesthetics has been a persistent challenge.

Traditional solar cells often require visible and separate panels that can detract from the visual appeal of the surrounding device or product. This limitation has hindered the seamless integration of solar energy solutions into various applications, such as electronic devices, and everyday used products.

To address these critical concerns, there is a clear need to improve the design of the electronic device incorporated with the solar cell structure to enhance the performance of the device. Furthermore, other desirable feature and characteristics will become apparent from the subsequent detailed description and the appended claims, taken in conjunction with the accompanying drawings and this background of the disclosure.

### SUMMARY OF INVENTION

One aspect of the present invention is a solar-powered mechanical keyboard comprising: a keyboard body with a plurality of keys, wherein each key is separately selectable by a user with a key press; a conductive layer with conductive traces, located beneath the keyboard body; a solar cell layer located beneath the conductive layer for absorbing light; and a circuitry in electrical connection to the solar cell layer and configured to supply power to the conductive layer; wherein each of the plurality of keys and the conductive layer is configured to define an air gap therebetween and each of the plurality of keys is configured to travel downward to make contact with the conductive traces of the conductive layer.

In some embodiments, the keyboard body and the conductive layer are transparent or translucent for capturing light.

In some embodiments, each of the plurality of keys is a dome structure for capturing light and providing click feel.

In some embodiments, the conductive traces are located at a top surface of the conductive layer.

In some embodiments, the keyboard further comprises a conductive contact at a bottom of each of the plurality of keys.

In some embodiments, the conductive contact of each key is configured to make electrical contact with the conductive traces of the conductive layer when the key is selected.

In some embodiments, there is a travelled distance during each key press providing click feel.

Some embodiments further comprise: a top adhesive layer for bonding the keyboard body and the conductive layer; and a bottom adhesive layer for bonding the conductive layer and the solar cell layer. The top and bottom adhesive layers are transparent or translucent. The bottom adhesive layer also functions as an insulative layer between the conductive layer and the solar cell layer.

In some embodiments, the thickness of the conductive layer is about 0.2 mm.

In some embodiments, a thickness of the solar cell layer is in the range of 1-2 mm.

In some embodiments, the keyboard further comprises a transparent or translucent top cover layer on the keyboard body, and the top cover layer is made of clear material.

In some embodiments, the top cover layer is textured to enhance the efficiency of light capture by directing natural or artificial light towards the solar cell layer.

In some embodiments, wherein the solar cell layer is made of silicon, amorphous silicon, polycrystalline silicon (polysilicon), Gallium Arsenide (GaAs), Cadmium Telluride (CdTe), Copper Indium Gallium Selenide (CIGS), or Perovskite.

In some embodiments, wherein the conductive layer, a conductive contact and the conductive traces include Indium Tin Oxide (ITO) or Indium Zinc Oxide (IZO).

In some embodiments, the keyboard further comprises a power storage unit with one or more rechargeable batteries or hybrid capacitors.

In some embodiments, the keyboard further includes a haptic motor to provide a simulated click feel for each key press.

In some embodiments, the keyboard further comprises a keyboard-signal transmission interface electrically connected to output signals of the conductive layer with a wiring or a wireless signal transmission module.

In some embodiments, the keyboard is configured for use as any one of a computer keyboard, a mouse, or a remote controller configured for use with a computer peripheral or consumer electronic device.

In some embodiments, there is provided a computer system comprising the any of the previous solar-powered mechanical keyboards, and a computing device connected to the keyboard for receiving input from the keyboard during operation.

Another aspect of the present invention is a method for manufacturing a solar cell-based keyboard, comprising the following steps: providing a solar cell layer for absorbing light; integrating a conductive layer with conductive traces located on top of the solar cell layer; mounting a keyboard body with a plurality of keys on top of the conductive layer, wherein each key is configured to be separately selectable by a user with a key press; and providing a circuitry in electrical connection to the solar cell layer and configured to supply power to the conductive layer; wherein each of the plurality of keys and the conductive layer is configured to define an air gap therebetween; wherein each of the plurality of keys is configured to travel downward to make contact with the conductive traces of the conductive layer.

It should be understood that the embodiments described herein are not exhaustive and that additional features and variations of the invention may be incorporated. Various other advantages and novel features of the invention will become apparent from the following detailed description when considered in conjunction with the accompanying drawings.

### BRIEF DESCRIPTION OF THE DRAWINGS

Embodiments of the present disclosure are described herein with reference to the drawings in which:
**FIG. 1** is a schematic diagram of a keyboard in accordance with an embodiment.
**FIG. 2A** is a cross-sectional side view of a keyboard with a solar cell in accordance with an embodiment with a plurality of keys.
**FIG. 2B** is a cross-sectional side view of a keyboard with a solar cell in accordance with an embodiment with one key.
**FIG. 2C** is a cross-sectional side view of a keyboard with an enlarged conductive layer in accordance with an embodiment.
**FIG. 3** is a comparison of power generation between a traditional prior art keyboard and the keyboard of the current invention in accordance with an embodiment.

### DETAILED DESCRIPTION

In the following detailed description, reference is made to the accompanying drawings, which form a part hereof.

Unless specified otherwise, the terms "comprising," "comprise," "including" and "include" used herein, and grammatical variants thereof, are intended to represent "open" or "inclusive" language such that they include recited elements but also permit inclusion of additional, un-recited elements. As used in this specification, the term "key", "key press", and "keyboard" relate to designs with mechanical keys (such as on a computer keyboard) and/or mechanical buttons (such as used on a remote control, security keypad, gaming console, or the like). Existing electronic product designs are often optimized for their intended functionality and aesthetics, leaving limited room for incorporating additional components like a solar cell. To address the issued discussed above, the current invention is developed an innovative approach to address the visual integration challenge of solar cells. This invention uses the underside surfaces of the product for incorporating a solar cell. These areas are often underutilized and can provide space for solar integration without impacting the primary user interface.

The invention involves the integration of solar cells underneath layers of transparent/translucent materials with conductive circuit that's invisible to the naked eye, effectively hiding the solar technology, still allowing efficient energy conversion, and maintaining tactile feedback or "click feel" on top of the solar cell. It's important to note that while these circuits may be invisible to the naked eye, they can still be detected and analysed using specialized equipment or techniques. Additionally, the electrical performance, durability, and reliability of conductive invisible circuits are important considerations during the design and implementation to ensure optimal functionality and longevity.

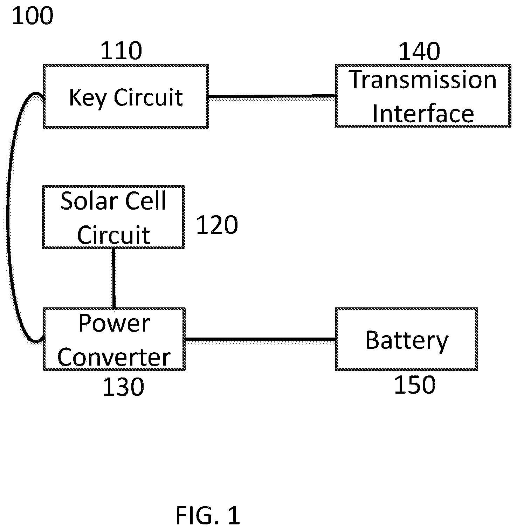

FIG. 1 is a schematic diagram of a solar-powered mechanical keyboard in accordance with an embodiment. As shown in FIG. 1, a solar-powered mechanical keyboard 100 of the present embodiment comprises a key circuit 110, a solar cell circuit 120, and a power converter 130. The key circuit 110 converts key presses from a user to electrical signals powered by the electricity received from the power converter 130. The power converter receives electricity generated by the solar cell circuit 120. Electrical power can be stored in a battery 150.

To enable seamless communication with computer hosts, the keyboard 100 is equipped with a keyboard-signal transmission interface 140. This interface 140 acts as a conduit, allowing the key circuit 110 to transmit signals effectively and securely to the connected computer host. Depending on design preferences, the keyboard-signal transmission interface 140 can be realized as a signal transmission wiring or a wireless signal transmission module, providing versatile connectivity options.

In a preferred embodiment, the keyboard 100 also includes a power storage unit with rechargeable battery 150. During daylight or when sufficient ambient light is available, the solar cell efficiently converts the incoming light into electrical power, powering the keyboard's circuitry directly. Additionally, any surplus energy generated is used to charge the onboard battery 150, ensuring it remains fully charged and ready for use.

However, in low-light conditions or when the keyboard is not exposed to sufficient light, the onboard battery seamlessly takes over, providing the necessary power to maintain uninterrupted functionality. The power management circuit automatically switches between solar energy and battery power, optimizing energy consumption and extending the battery life.

The solar-powered mechanical keyboard is an innovative and environmentally friendly input device that integrates a thin, flexible solar cell layer into its design. This revolutionary keyboard is designed to harness solar energy efficiently, enabling it to operate without the need for traditional batteries or constant reliance on electrical outlets. The solar cell layer is seamlessly integrated into the upper surface of the keyboard, ensuring a sleek and unobtrusive appearance while maximizing exposure to sunlight or artificial light sources.

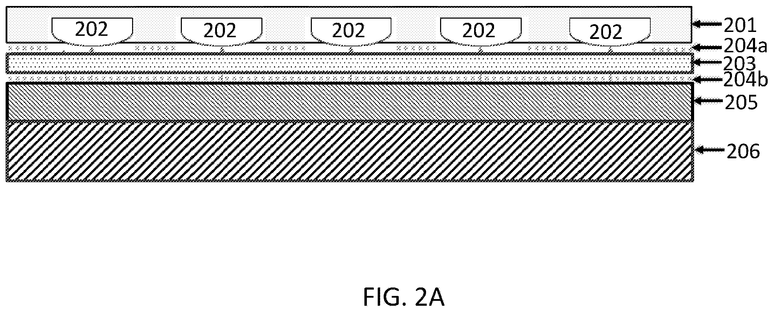

FIG. 2A is a cross-sectional side view of the solar-powered mechanical keyboard 100 in accordance with an embodiment. The solar-powered mechanical keyboard 100 includes a keyboard body 201 with a plurality of keys 202, a conductive layer 203, a top adhesive layer 204a, a bottom adhesive layer 204b, a solar cell layer 205, and a base layer 206. Air gaps, not shown in FIG. 2A, are located between each key 202 and the conductive layer 203 to permit movement of the keys 202 when each key is selected by a user with a key press. The keyboard body 201 (including its keys 202), the conductive layer 203, the top adhesive layer 204a, and the bottom adhesive layer 204b can each be transparent or translucent.

Concealing the solar cell layer 205 in the invention employs a combination of technologies that seamlessly hide the solar cell layer 205 while harnessing solar energy impacting the surface area of the keys 202 of the keyboard 100. Use of translucent materials has the benefit of receiving the solar energy while maintaining the functionality and aesthetics of the keyboard 100.

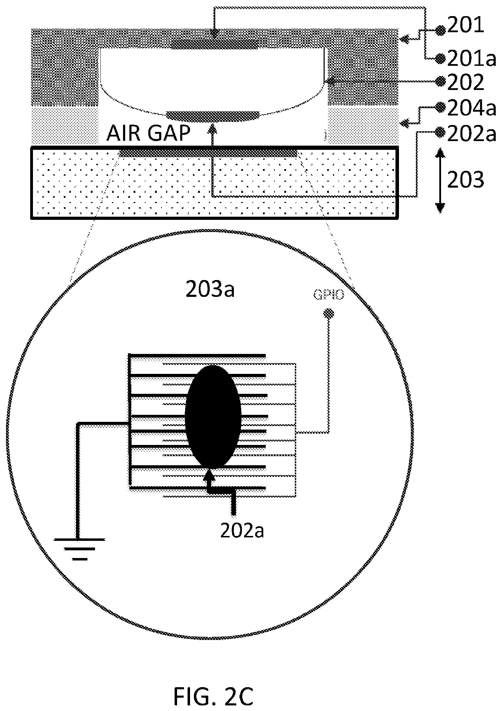

The keyboard body 201 occupies the topmost position and includes a transparent/translucent top cover layer for the keyboard 100. This cover layer allows ambient light to pass through, ensuring optimal light accessibility for subsequent layers. The keys 202 for the keyboard 100 are embedded into the keyboard body 201, forming an essential component of the keyboard. Alternatively, the keyboard body 201 may also be shaped to include dome structures of keys 202 as a single component. Therefore, the keyboard body 201 and the keys 202 can be integrated into one single part. The conductive layer 203 comprises conductive traces 203a (see FIG. 2C) for registering key presses on the keys by a user. The conductive traces 203a (see FIG. 2C) are electrically connected to circuit for communicating the electrical signals from the key presses to the host computer. The transparent/translucent nature enables the passage of light through the keyboard body 202 and the conductive layer 203 to the solar cell layer 205. Positioned below the keys 202, the solar cell layer 205 absorbs and converts the incoming ambient light into electrical power. This light-to-electricity conversion makes the keyboard self-charging and energy-efficient.

The conductive layer 203 provides electrical connection between the keyboard body 201 and the keyboard-signal transmission interface 140 (interface 140 shown in FIG. 1). The top adhesive layer 204a connects the keyboard body 201 and the conductive layer 203. The bottom adhesive layer 204b connects the conductive layer 203 and the solar cell layer 205. The solar cell layer 205 is a flexible photovoltaic module, supported by the base layer 206. Alternatively a rigid photovoltaic module may be used. In order to achieve the real "click feel" for the users during a key press, an air gap is defined between each of the keys 202 and the conductive layer 203. Therefore, when a user interacts with the keyboard 100, such as by pressing a key 202 of the keyboard, the key 202 would move downward to travel through the air gap and make an electrical contact with the conductive layer 203. The electrical signal resulting from the key press communicates the key selection to the host computer to detect the user input. This innovative structure optimizes both the user click experience and the solar energy absorption efficiency.

The solar cells incorporated can convert both natural and artificial light into electrical energy. This allows the device to harness energy from various light sources, ensuring a continuous power supply. The design is also versatile and adaptable to surface area that could even be textured. It allows device makers to incorporate such design without compromising the traditional appearance or functionality of the product. Finally with the integrated layers of conductive materials or traces, allowing the same surface area where the solar cells lie underneath to provide clickable functionality.

In summary, the invention is a technology that can be applied to an existing surface area of majority electronic devices. Using the surface with a solar cell layer hidden beneath it to generate solar energy to power the keyboard. Referencing to FIG. 2A, this approach involves the use of customized and flexible photovoltaic modules that mimic the appearance of the surface that is applied to, effectively hiding the solar cells while still able to harness light. By applying layers of transparent or translucent materials on top of the solar cells with electronically conductive materials doubles up the same surface to be used as an input device, which in turn can be commonly used in computer peripherals or consumer electronic devices, such as keyboards, mouse, remote controllers, and many others input devices.

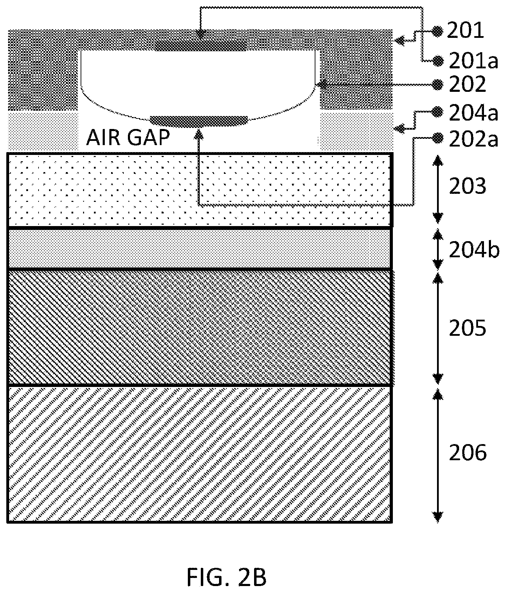

FIG. 2B is a cross-sectional side view of an embodiment of the solar-powered mechanical keyboard 100. FIG. 2B illustrates only one key 202 of the plurality of keys of the embodiment. The keyboard 100 includes a transparent or translucent top cover layer of the keyboard body 201, which allows the light to pass through. The top cover layer of the keyboard body 201 is typically composed of transparent or translucent materials like, clear plastic acrylic film of less than 0.5mm. These materials allow light to pass through, creating a visually appealing effect. The surface of the material can also be textured to enhance the seamlessness blending of the material with the surrounding material of the product.

A transparent or translucent key 202 is located below the top cover layer of the keyboard body 201. A key sign 201a is printed on the top surface of the key 202. The key sign 201a can be numbers, letters, logos, symbols, or any other necessary functions. Printing on the top cover layer of the keyboard body 201 ensures the printing is easily readable and understandable. The key 202 may bump upwards convexly instead of flat-surfaced.

The key 202 can be made of the poly-dome sheet with a travel distance to contact with the bottom conductive layer 203. A dome structure of the keys 202 can be helpful to trap the light within the structure to enhance the light absorption efficiency. The dome structure of the key 202 portrayed in FIGs. 2A-2C can function as a light guide which concentrates light towards the solar cell. It ensures that even in low-light environments, the solar cell efficiently capture the ambient light, improving the energy conversion and performance. Furthermore, the dome structure is also helpful to provide the click feel.

The key 202 allow light to pass through, which is beneficial in this invention. The transparent/translucent nature of the top cover layer of the keyboard body 201 and the keys 202 allows the light to shine through to a solar cell layer 205, while providing tactile feedback in user interface applications. The bottom portion of the key 202 is a conductive contact 202a (refer to detailed explanation of FIG. 2C) that acts to electrically connect two sides of a circuit by contact with the conductive traces 203a (see FIG. 2C) during a key press.

The top cover layer of the keyboard body 201, the keys 202 and the conductive layer 203 can be either transparent or translucent. When those layers are translucent, the solar cells are not readily visible to the user and the keyboard surface appearance is not mired by the colours or structure of the solar cells. Hence, it can reduce the colour discrepancy between the surrounding area of the keyboard device. While when the layers are transparent, the transparency limits the design options for labelling and graphic elements. The colour choices and design elements are typically limited to ensure legibility and clarity. This constraint may limit the creativity and customization possibilities when compared to devices with large fill up graphical elements (e.g., white background).

Top adhesive layer 204a and bottom adhesive layer 204b that creates a clear and transparent bond between two surfaces are carefully selected. The top adhesive layer 204a is used for connecting the top cover layer of the keyboard body 201 and the conductive layer 203. The bottom adhesive layer 204b is used for connecting the conductive layer 203 and the solar cell layer 205. The thickness of the top and bottom adhesive layers 204a/204b should be thin and is about 0.125 mm. The bottom adhesive layer 204b is also function as an insulating layer to separate the electrical connection between the key 202 and the solar cell layer 205. It is designed to join the transparent/translucent materials to maintaining optical clarity to allow light to pass through. These could be a choice of optical clear adhesive materials or EVA-based adhesive or a combination of in the entire layers stack up during the bonding process. Between the key layer 202 and the conductive layer 203, there also provides an air gap between the key 202 and the conductive layer 203, allowing a key travel to contact between these two layers.

The solar cell layer 205 is positioned below the key 202, and it absorbs the ambient light to generate electric power. The solar cell is typically made using silicon-based materials with a film thickness about 1-2 mm. The material of the solar cell for the keyboard can indeed vary based on design preferences and technological advancements. Some common materials for solar cells include silicon, amorphous silicon, polycrystalline silicon (polysilicon), Gallium Arsenide (GaAs), as well as other materials like Cadmium Telluride (CdTe), Copper Indium Gallium Selenide (CIGS), and Perovskite etc. The solar cell layer 205 is made on top of the base layer 206 with a thickness at the range of 3-5 mm. The base layer 206 is made of, for example, plastics.

Extensive experimentation and prototyping have been conducted to optimize the design, considering factors such as light transmission, structural integrity, and usability management. The goal is to achieve a balance between efficient energy conversion, visually appealing seamless integration, and functionality over the surface area of the solar cell.

By hiding the solar cells beneath transparent or translucent layers, it addresses the challenges of integrating solar technology into various environments without compromising the visual appeal. In addition, having a layer of transparent or translucent conductive material in between the solar cell and the surface area addresses one of the main problems for solar cell devices, which is finding more surface area to increase more light conversion into electricity. Users can also enjoy the benefits of solar energy without the need for separate, visible solar panels, offering new possibilities for incorporating solar power into everyday products.

The potential applications for the current invention are vast. By integrating solar cells beneath functional keys or an existing surface area, it can incorporate solar energy generation into electronic devices without compromising their functionality or aesthetics. Transforming an existing product with limited surface area of a separate solar cell into a solar harvesting area. The current invention can contribute to the wider adoption of renewable energy sources and pave the way for a more sustainable future.

FIG. 2C is a cross-sectional side view of a portion of a solar-powered mechanical keyboard 100 with an enlarged view of the conductive layer 203 in accordance with an embodiment. Reference to FIG. 2C, on the top surface of the conductive layer 203, there are a pair of comb-shaped conductive traces 203a to direct electrical signals to the product's main circuit board via a flex cable when a key is pressed. The conductive contact 202a on each key 202 will interact with the two comb-shaped conductive traces 203a to complete an electrical circuit upon a key press. Transparent conductive materials, such as indium tin oxide (ITO) or indium zinc oxide (IZO), can be used for the conductive contact 202a and the conductive traces 203a. This then ensures the transparent area remain clear to allow light transmission to the lower surface where the solar cells are incorporated.

The user can provide user inputs by key presses applied to the top surface of the keyboard body 201. For instance, the user can press on the key signs 201a to key press. The key 202 would move down to make a contact with conductive traces 203a of the conductive layer 203 to complete the circuit. The key press electrically connects two separated combed sides of the conductive traces 203a, permitting an electrical signal to be transmitted to a keyboard-signal transmission interface (e.g., interface 140 shown in FIG. 1). Therefore, the host computer would be aware that specific keys 202 were pressed and by the user.

The layers that manage the electric signal conduction are to be connected seamlessly with the internal circuitry of the product. This involves properly aligning the conductive traces 203a with the key 403 and appropriate connections to the product's main circuit board via a flex cable.

The keyboard incorporates an innovative key-press detection system that seamlessly links each key to the underlying circuitry. When a key is pressed, a precise and instantaneous electrical connection is established between the corresponding key and the circuit, enabling the system to accurately detect and register the specific key press.

The key-press detection mechanism ensures high responsiveness and precision during typing, as the circuit rapidly processes the electrical signals generated when keys are pressed. Each key is uniquely mapped to its electrical signature, allowing the system to identify the exact key pressed and translate it into the corresponding character or action on the connected device.

In one embodiment, a haptic motor will be provided to enhance the "click feel" for each key press. Alternatively, the keyboard can be implemented based on the capacitance touch technology. The capacitive layer is typically made of a transparent conductor, such as ITO or IZO. When a user touches the surface with their finger or a conductive object, it creates a coupling effect between the user's touch and the capacitive layer.

In another embodiment, the keyboard can be implemented based on the resistive touch technology. A resistive touch technology consists of multiple layers, typically two transparent conductive layers separated by a small gap. The conductive layers are also usually made of ITO or IZO, which is coated onto a flexible substrate, such as polyester. The inner surface of each conductive layer is coated with a resistive material, such as a thin layer of microscopic dots or a conductive polymer. When pressure is applied to the surface of a resistive touch, the conductive traces on the top of the conductive layer come into contact with the conductive contact of the keys during a key press by a user. This contact creates an electrical connection between the two sides of the conductive traces at that specific location, altering the resistance in the circuit.

In conclusion, the successful arrangement of the solar cell layer beneath the keyboard body is a delicate balance between efficient light capture, user comfort, and seamless integration. The goal is to create a solar-powered mechanical keyboard that maximizes sustainability and usability while providing a familiar and enjoyable typing experience for users. Since the surface area under the keys is utilized for the solar cell, there is no need to arrange the key on a separate area from the solar cells area. The surface of the user interface including the keys/buttons generates power to the device. Thus, the area of the solar cell unit, which generates energy from incoming light, can be maximized with a minimum footprint. The invention makes it possible to increase the area of the solar cell unit, without increasing the size of the electronic device. This significantly increases the power generated by the solar cell layer of the keyboard. The invention is well suited for the buttons and/or key pads of remote controls and computer keyboards; it can also be used for any devices or product with an input interface such as mouse, keypad, buttons and switches, and touchpads. It can be noted that the term "key" is meant to include both keypad keys and buttons in this specification.

Therefore, the current invention can achieve multiple advantages. For example: Aesthetics: Concealed solar cells are designed to be discreet and blend seamlessly with the product's surrounding look and feel without compromising the overall aesthetics or visual appeal.

Space Optimization: Concealed solar cells make efficient use of available spaces. By integrating solar cells into existing surfaces or structures, it can utilize otherwise unused or underutilized areas for power generation. This is particularly beneficial for products with limited dedicated surface area for traditional solar cell integration.

Improved Durability: Concealed solar cells can benefit from added protection and durability. The solar cells are shielded from direct exposure to external elements, such as physical impacts. This can enhance their lifespan and reliability, reducing maintenance requirements.

Enhanced Functionality: With the addition of conductive material over the concealed solar cells offers additional functionality beyond power generation. For example, an input device with keys or buttons having solar cell concealed beneath, provides key presses functionality while simultaneously generating electricity. This dual functionality adds value and versatility to the concealed solar cell technology.

Environmental Impact: Solar cells contribute to sustainable energy generation and help reduce carbon emissions. By harnessing solar energy, they promote clean and renewable power sources, reducing reliance on single use batteries. This benefits the environment by mitigating climate change and promoting a greener future.

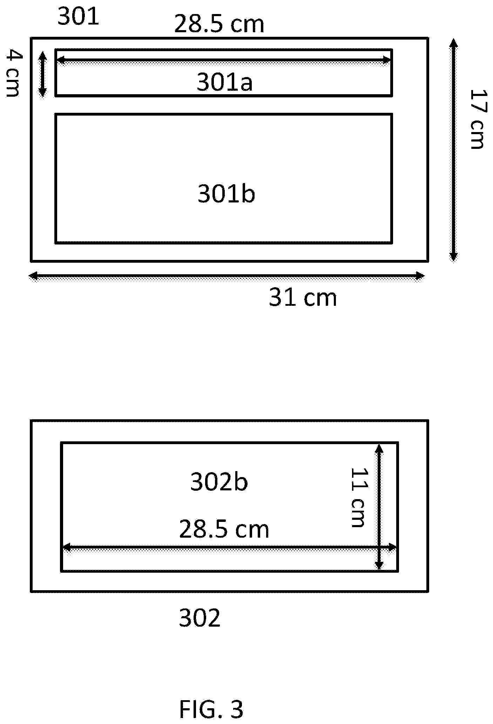

FIG. 3 is a comparison between the traditional keyboard and the current invention with the solar cell beneath in accordance with an embodiment. On the top of FIG. 3 is the traditional prior art solar keyboard 301 with a standard keyboard area 301b and a rectangular exposed solar cell area 301a along a top portion of the prior art solar keyboard 301. On the bottom of FIG. 3 is the sample keyboard of the invention 302 with the key area 302b having a solar cell layer 205 located beneath the keyboard body 201.

Below is a table of comparison between the current invention and the traditional keyboard with the solar cell in accordance with an embodiment. To put this inventive design into perspective, the below table is an estimated power output based on prior art solar-powered keyboard (column 1 of the table) with a smaller form factor solar-powered mechanical keyboard of the invention (column 2 of the table).

| **Prior Art Solar Keyboard (solar cells in top rectangle area only)** | **Invention Design (solar cell layer under keys)** |
|---|---|
| Dedicated space, larger form factor | Re-use existing device area, reduced form factor |
| Solar surface area ~114 cm² | Solar surface area ~313 cm² |
| | 2.7x more area for solar |
| | Doubles or more energy harvesting |

With the multitude layers incorporated in this inventive design will generally have a lower conversion efficiency compared to solar cells on its' own. This is due to the trade-off with the additional transparency or translucent layers that increases the thickness which in turn reduces the light absorption and optical losses, reduces the overall efficiency of the solar cell. However, this is compensated by the additional surface area given with this invention design.

On this specific comparison of FIG. 3, the power output of the current invention is estimated to increase, with more than 2.5 times of surface area than the prior art solar keyboard 301.

## Claims

1. A solar-powered mechanical keyboard (100) comprising:
- a keyboard body (201) with a plurality of keys (202), wherein each key (202) is separately selectable by a user with a key press;
- a conductive layer (203) with conductive traces (203a), located beneath the keyboard body (201);
- a solar cell layer (205) located beneath the conductive layer (203) for absorbing light; and
- a circuitry (110, 120, 130) in electrical connection to the solar cell layer (205) and configured to supply power to the conductive layer (203); wherein each of the plurality of keys (202) and the conductive layer (203) is configured to define an air gap therebetween;
wherein each of the plurality of keys (202) is configured to travel downward to make contact with the conductive traces (203a) of the conductive layer (203).

2. The keyboard of claim 1, wherein the keyboard body and the conductive layer are transparent or translucent for capturing light.

3. The keyboard of claim 1, wherein each of the plurality of keys is a dome structure for capturing light and providing click feel.

4. The keyboard of claim 1, wherein the conductive traces are located at a top surface of the conductive layer.

5. The keyboard of claim 1, further comprising a conductive (202a) contact at a bottom of each of the plurality of keys.

6. The keyboard of claim 5, wherein the conductive contact of each key is configured to make electrical contact with the conductive traces of the conductive layer when the key is selected.

7. The keyboard of claim 1, wherein each of the keys travels a distance during each key press by clicking on the key.

8. The keyboard of claim 1, further comprising:
a top adhesive layer ( 204a) for bonding the keyboard body and the conductive layer; and
a bottom adhesive layer (204b) for bonding the conductive layer and the solar cell layer,
wherein the top and bottom adhesive layers are transparent or translucent; and
wherein the bottom adhesive layer also functions as an insulative layer between the conductive layer and the solar cell layer.

9. The keyboard of claim 1, wherein a thickness of the conductive layer is around 0.2 mm.

10. The keyboard of claim 1, wherein a thickness of the solar cell layer is in the range of 1-2 mm.

11. The keyboard of claim 1, further comprising a transparent or translucent top cover layer (201a) on the keyboard body, wherein the top cover layer is made of clear material.

12. The keyboard of claim 11, wherein the top cover layer is textured to enhance the efficiency of light capture by directing natural or artificial light towards the solar cell layer.

13. The keyboard of claim 1, wherein the solar cell layer is made of silicon, amorphous silicon, polycrystalline silicon (polysilicon), Gallium Arsenide (GaAs), Cadmium Telluride (CdTe), Copper Indium Gallium Selenide (CIGS), or Perovskite.

14. The keyboard of claim 1, wherein the conductive layer, a conductive contact (202a), and the conductive traces include Indium Tin Oxide (ITO) or Indium Zinc Oxide (IZO).

15. The keyboard of claim 1, further comprising a power storage unit (150) with one or more rechargeable batteries or hybrid capacitors.

16. The keyboard of claim 1, wherein the keyboard further includes a haptic motor configured to provide a simulated click feel for each key press.

17. The keyboard of claim 1, further comprising a keyboard-signal transmission interface (140) electrically connected to output signals of the conductive layer with a wiring or a wireless signal transmission module.

18. The keyboard of claim 1, wherein the keyboard is configured for use as any one of a computer keyboard, a mouse, or a remote controller configured for use with a computer peripheral or consumer electronic device.

19. A computer system comprising:
the keyboard of claim 1; and
a computing device connected to the keyboard for receiving input from the keyboard during operation.

20. A method for manufacturing a solar-powered mechanical keyboard according to claim 1, comprising the following steps:
- providing a solar cell layer for absorbing light;
- integrating a conductive layer with conductive traces located on top of the solar cell layer;
- mounting a keyboard body with a plurality of keys on top of the conductive layer and on top of the solar cell layer, wherein the solar cell layer is beneath the plurality of keys and beneath the conductive layer, wherein each key is configured to be separately selectable by a user with a key press; and
- providing a circuitry in electrical connection to the solar cell layer and configured to supply power to the conductive layer;
wherein each of the plurality of keys and the conductive layer is configured to define an air gap therebetween;
wherein each of the plurality of keys is configured to travel downward to make contact with the conductive traces of the conductive layer.

## Patentansprüche

1. Solarbetriebene mechanische Tastatur (100), umfassend:
- einen Tastaturkörper (201) mit einer Vielzahl von Tasten (202), wobei jede Taste (202) durch einen Benutzer mit einem Tastendruck separat auswählbar ist;
- eine leitfähige Schicht (203) mit leitfähigen Spuren (203a), die sich unter dem Tastaturkörper (201) befinden;
- eine Solarzellenschicht (205), die sich zum Absorbieren von Licht unter der leitfähigen Schicht (203) befindet; und
- eine Schaltung (110, 120, 130) in elektrischer Verbindung mit der Solarzellenschicht (205) und dazu konfiguriert, Leistung an die leitfähige Schicht (203) bereitzustellen; wobei jede der Vielzahl von Tasten (202) und die leitfähige Schicht (203) dazu konfiguriert sind, dazwischen einen Luftspalt zu definieren;
wobei jede der Vielzahl von Tasten (202) dazu konfiguriert ist, sich abwärts zu bewegen, um mit den leitfähigen Spuren (203a) der leitfähigen Schicht (203) in Kontakt zu treten.

2. Tastatur nach Anspruch 1, wobei der Tastaturkörper und die leitfähige Schicht zum Erfassen von Licht durchsichtig oder durchscheinend sind.

3. Tastatur nach Anspruch 1, wobei jede der Vielzahl von Tasten eine Kuppelstruktur zum Erfassen von Licht und Bereitstellen eines Klickgefühls ist.

4. Tastatur nach Anspruch 1, wobei sich die leitfähigen Spuren an einer oberen Oberfläche der leitfähigen Schicht befinden.

5. Tastatur nach Anspruch 1, ferner umfassend einen leitfähigen (202a) Kontakt an einer Unterseite jeder der Vielzahl von Tasten.

6. Tastatur nach Anspruch 5, wobei der leitfähige Kontakt jeder Taste dazu konfiguriert ist, mit den leitfähigen Spuren der leitfähigen Schicht in Kontakt zu treten, wenn die Taste ausgewählt wird.

7. Tastatur nach Anspruch 1, wobei sich jede der Taste während jedes Tastendrucks durch Anklicken der Taste um einen Abstand bewegt.

8. Tastatur nach Anspruch 1, ferner umfassend:
eine obere Haftschicht (204a) zum Binden des Tastaturkörpers und der leitfähigen Schicht; und eine untere Haftschicht (204b) zum Binden der leitfähigen Schicht und der Solarzellenschicht, wobei die obere und die untere Haftschicht durchsichtig oder durchscheinend sind; und
wobei die untere Haftschicht ebenfalls als eine Isolierschicht zwischen der leitfähigen Schicht und der Solarzellenschicht fungiert.

9. Tastatur nach Anspruch 1, wobei eine Dicke der leitfähigen Schicht ungefähr 0,2 mm beträgt.

10. Tastatur nach Anspruch 1, wobei eine Dicke der Solarzellenschicht in dem Bereich von 1-2 mm liegt.

11. Tastatur nach Anspruch 1, ferner umfassend eine durchsichtige oder durchscheinende obere Abdeckungsschicht (201a) auf dem Tastaturkörper, wobei die obere Abdeckungsschicht aus klarem Material hergestellt ist.

12. Tastatur nach Anspruch 11, wobei die obere Abdeckungsschicht dazu texturiert ist, die Effizienz der Lichterfassung durch Richten natürlichen oder künstlichen Lichts in Richtung der Solarzellenschicht zu verbessern.

13. Tastatur nach Anspruch 1, wobei die Solarzellenschicht aus Silicium, amorphem Silicium, polykristallinem Silicium (Polysilicium), Galliumarsenid (GaAs), Cadmiumtellurid (CdTe), Kupfer-Indium-Gallium-Diselenid (CIGS) oder Perowskit hergestellt ist.

14. Tastatur nach Anspruch 1, wobei die leitfähige Schicht, ein leitfähiger Kontakt (202a) und die leitfähigen Spuren Indiumzinnoxid (ITO) oder Indiumzinkoxid (IZO) beinhalten.

15. Tastatur nach Anspruch 1, ferner umfassend eine Leistungsspeichereinheit (150) mit einer oder mehreren wiederaufladbaren Batterien oder hybriden Kondensatoren.

16. Tastatur nach Anspruch 1, wobei die Tastatur ferner einen haptischen Motor beinhaltet, der dazu konfiguriert ist, ein simuliertes Klickgefühl für jeden Tastendruck bereitzustellen.

17. Tastatur nach Anspruch 1, ferner umfassend eine Tastatursignalübertragungsschnittstelle (140), die mit einer Verdrahtung oder einem drahtlosen Signalübertragungsmodul elektrisch mit Ausgabesignalen der leitfähigen Schicht verbunden ist.

18. Tastatur nach Anspruch 1, wobei die Tastatur zur Verwendung als eine beliebige einer Computertastatur, einer Maus oder einer Fernsteuerung konfiguriert ist, die zur Verwendung mit einem Computerperipheriegerät oder einer elektronischen Verbrauchervorrichtung konfiguriert ist.

19. Computersystem, umfassend:
die Tastatur nach Anspruch 1; und
eine Rechenvorrichtung, die mit der Tastatur verbunden ist, zum Empfangen einer Eingabe von der Tastatur während einer Betätigung.

20. Verfahren zum Herstellen einer solarbetriebenen mechanischen Tastatur nach Anspruch 1, umfassend die folgenden Schritte:
- Bereitstellen einer Solarzellenschicht zum Absorbieren von Licht;
- Integrieren einer leitfähigen Schicht mit leitfähigen Spuren, die sich oben auf der Solarzellenschicht befinden;
- Montieren eines Tastaturkörpers mit einer Vielzahl von Tasten oben auf der leitfähigen Schicht und oben auf der Solarzellenschicht, wobei sich die Solarzellenschicht unter der Vielzahl von Tasten und unter der leitfähigen Schicht befindet, wobei jede Taste dazu konfiguriert ist, durch einen Benutzer mit einem Tastendruck separat auswählbar zu sein; und
- Bereitstellen einer Schaltung in elektrischer Verbindung mit der Solarzellenschicht und dazu konfiguriert, Leistung an die leitfähige Schicht bereitzustellen;
wobei jede der Vielzahl von Tasten und die leitfähige Schicht dazu konfiguriert sind, dazwischen einen Luftspalt zu definieren;
wobei jede der Vielzahl von Tasten dazu konfiguriert ist, sich abwärts zu bewegen, um mit den leitfähigen Spuren der leitfähigen Schicht in Kontakt zu treten.

## Revendications

1. Clavier mécanique à énergie solaire (100) comprenant :
- un corps de clavier (201) avec une pluralité de touches (202), dans lequel chaque touche (202) peut être sélectionnée séparément par un utilisateur par une pression de touche ;
- une couche conductrice (203) avec des pistes conductrices (203a), située en dessous du corps de clavier (201) ;
- une couche de cellules solaires (205) située en dessous de la couche conductrice (203) pour absorber la lumière ; et
- un ensemble de circuits (110, 120, 130) relié électriquement à la couche de cellules solaires (205) et configuré pour fournir de l'énergie à la couche conductrice (203) ; dans lequel la pluralité de touches (202) et la couche conductrice (203) sont chacune configurées pour définir une lame d'air entre elles ; dans lequel chacune de la pluralité de touches (202) est configurée pour se déplacer vers le bas de manière à établir un contact avec les pistes conductrices (203a) de la couche conductrice (203).

2. Clavier selon la revendication 1, dans lequel le corps de clavier et la couche conductrice sont transparents ou translucides pour capturer la lumière.

3. Clavier selon la revendication 1, dans lequel chacune de la pluralité de touches est une structure en dôme pour capturer la lumière et fournir une sensation de clic.

4. Clavier selon la revendication 1, dans lequel les pistes conductrices sont situées au niveau d'une surface supérieure de la couche conductrice.

5. Clavier selon la revendication 1, comprenant en outre un contact conducteur (202a) au niveau d'une partie inférieure de chacune de la pluralité de touches.

6. Clavier selon la revendication 5, dans lequel le contact conducteur de chaque touche est configuré pour établir un contact électrique avec les pistes conductrices de la couche conductrice lorsque la touche est sélectionnée.

7. Clavier selon la revendication 1, dans lequel chacune des touches parcourt une distance pendant chaque pression de touche par un clic sur la touche.

8. Clavier selon la revendication 1, comprenant en outre :
une couche adhésive supérieure (204a) pour lier le corps de clavier et la couche conductrice ; et une couche adhésive inférieure (204b) pour lier la couche conductrice et la couche de cellules solaires, dans lequel les couches adhésives supérieure et inférieure sont transparentes ou translucides ; et
dans lequel la couche adhésive inférieure sert également de couche isolante entre la couche conductrice et la couche de cellules solaires.

9. Clavier selon la revendication 1, dans lequel une épaisseur de la couche conductrice est d'environ 0,2 mm.

10. Clavier selon la revendication 1, dans lequel une épaisseur de la couche de cellules solaires est dans la plage de 1 à 2 mm.

11. Clavier selon la revendication 1, comprenant en outre une couche de couverture supérieure (201a) transparente ou translucide sur le corps de clavier, dans lequel la couche de couverture supérieure est constituée d'un matériau transparent.

12. Clavier selon la revendication 11, dans lequel la couche de couverture supérieure est texturée pour améliorer l'efficacité de la capture de lumière en dirigeant la lumière naturelle ou artificielle vers la couche de cellules solaires.

13. Clavier selon la revendication 1, dans lequel la couche de cellules solaires est constituée de silicium, de silicium amorphe, de silicium polycristallin (polysilicium), d'arséniure de gallium (GaAs), de tellurure de cadmium (CdTe), de séléniure de cuivre, d'indium et de gallium (CIGS), ou de pérovskite.

14. Clavier selon la revendication 1, dans lequel la couche conductrice, un contact conducteur (202a) et les pistes conductrices comportent de l'oxyde d'indium-étain (ITO) ou de l'oxyde d'indium-zinc (IZO).

15. Clavier selon la revendication 1, comprenant en outre une unité de stockage d'énergie (150) avec une ou plusieurs batteries rechargeables ou condensateurs hybrides.

16. Clavier selon la revendication 1, dans lequel le clavier comporte en outre un moteur haptique configuré pour fournir une sensation de clic simulée pour chaque pression de touche.

17. Clavier selon la revendication 1, comprenant en outre une interface de transmission de signal de clavier (140) reliée électriquement à des signaux de sortie de la couche conductrice avec un câblage ou un module de transmission de signal sans fil.

18. Clavier selon la revendication 1, dans lequel le clavier est configuré pour être utilisé comme l'un quelconque parmi un clavier d'ordinateur, une souris ou un dispositif de commande à distance configuré pour être utilisé avec un périphérique d'ordinateur ou un dispositif électronique grand public.

19. Système informatique, comprenant :
le clavier selon la revendication 1 ; et
un dispositif informatique relié au clavier pour recevoir une entrée provenant du clavier pendant le fonctionnement.

20. Procédé de fabrication d'un clavier mécanique à énergie solaire selon la revendication 1, comprenant les étapes suivantes :
- la fourniture d'une couche de cellules solaires pour absorber la lumière ;
- l'intégration d'une couche conductrice avec des pistes conductrices situées au-dessus de la couche de cellules solaires ;
- le montage d'un corps de clavier avec une pluralité de touches au-dessus de la couche conductrice et au-dessus de la couche de cellules solaires, dans lequel la couche de cellules solaires est en dessous de la pluralité de touches et en dessous de la couche conductrice, dans lequel chaque touche est configurée pour pouvoir être sélectionnée séparément par un utilisateur par une pression de touche ; et
- la fourniture d'un ensemble de circuits relié électriquement à la couche de cellules solaires et configuré pour fournir de l'énergie à la couche conductrice ;
dans lequel la pluralité de touches et la couche conductrice sont chacune configurées pour définir une lame d'air entre elles ;
dans lequel chacune de la pluralité de touches est configurée pour se déplacer vers le bas de manière à établir un contact avec les pistes conductrices de la couche conductrice.
